# FASCICULE DE BREVET EUROPEEN

(11) **EP 2 960 937 B1**
(45) Date de publication et mention de la délivrance du brevet: **16.05.2018**
(21) Numéro de dépôt: 15173470.4
(22) Date de dépôt: 23.06.2015
(51) Int. Cl.: H01L 23/367, H01L 23/433, H01L 25/03, H01L 25/065, H01L 23/42

(54) **CIRCUIT INTEGRE COMPORTANT UN DISSIPATEUR DE CHALEUR**
INTEGRIERTER SCHALTKREIS, DER EINEN WÄRMEABLEITER UMFASST
INTEGRATED CIRCUIT COMPRISING A HEAT SINK

(30) Priorité: 25.06.2014 FR 1455936
(43) Date de publication de la demande: 30.12.2015
(73) Titulaire: Commissariat à l'Énergie Atomique et aux Énergies Alternatives, 75015 Paris (FR)
(72) Inventeur: BEN JAMAA, Haykel, 38000 GRENOBLE (FR); FULBERT, Laurent, 38500 VOIRON (FR); MENEZO, Sylvie, 38500 VOIRON (FR); POUPON, Gilles, 38170 SEYSSINET PARISET (FR)
(74) Mandataire: Colombo, Michel

(56) Documents cités:
- EP-A2- 1 271 649
- JP-A- 2013 008 748
- US-A1- 2006 039 118
- US-A1- 2008 237 840
- US-A1- 2009 127 700
- US-A1- 2013 043 581

## Description

L'invention concerne un circuit intégré comportant un dissipateur de chaleur. L'invention a également pour objet un ensemble comportant ce circuit intégré ainsi qu'un procédé de fabrication de ce circuit intégré.

L'évolution des circuits intégrés pendant les dernières décennies a été dans le sens de l'augmentation de la fonctionnalité grâce à la réduction des dimensions lithographiques, en suivant la loi dite de « Moore ». Depuis moins d'une décennie, des fonctionnalités peuvent être ajoutées au circuit intégré en utilisant les possibilités offertes par l'intégration suivant la dimension verticale, dite intégration 3D. Cette augmentation de la densité d'intégration dans les trois dimensions disponibles du circuit intégré a eu comme conséquence directe l'augmentation de la densité de puissance, engendrant une augmentation de la température des jonctions des transistors, et en général de la température d'opération des puces électroniques.

Ainsi, des circuits intégrés connus comportent :
- un substrat qui s'étend principalement dans un plan appelé « plan du substrat », ce substrat étant équipé de connexions électriques pour raccorder électriquement le circuit intégré à un circuit électronique extérieur, ce substrat présentant une face intérieure,
- une puce électronique haute et une puce électronique basse, chacune de ces puces électroniques étant électriquement raccordée aux connexions électriques par l'intermédiaire de ce substrat et chaque puce électronique comportant une face avant tournée vers la face intérieure du substrat et une face arrière du côté opposé à cette face avant, la face arrière de la puce électronique haute étant située à une hauteur H au-dessus de la face intérieure du substrat et étant plus éloignée de la face intérieure du substrat que la face arrière de la puce électronique basse,
- un boîtier formé par une couche épaisse en matériau électriquement isolant qui enrobe les puces électroniques, cette couche épaisse formant une face extérieure supérieure du boîtier parallèle au plan du substrat.

De tels circuits intégrés sont refroidis par l'intermédiaire de leur face extérieure supérieure. Par exemple, à cet effet, un système de refroidissement est fixé sur cette face extérieure supérieure.

Toutefois, la puce électronique basse est moins bien refroidie que la puce électronique haute car elle est plus éloignée de la face extérieure supérieure. Dans ces conditions, pour éviter un échauffement trop important de la puce électronique basse, une solution consiste à surdimensionner le système de refroidissement de la face extérieure supérieure pour tenir compte de cet éloignement par rapport à la puce électronique basse. Une autre solution consiste à ne rien faire et à s'accommoder du fait que la puce électronique basse et moins bien refroidie que la puce électronique haute. Enfin, d'autres solutions consistent à introduire un dissipateur de chaleur, dépourvu de composants électroniques, entre la face arrière de la puce électronique basse et la face extérieure supérieure du boîtier. Ce dissipateur comporte une face avant disposée sur la face arrière de la puce électronique basse et une face arrière du côté opposé à la face avant, cette face arrière étant située au même niveau que la face arrière de la puce électronique haute. Des exemples de cette dernière solution sont décrits dans les demandes US2009/127700A1 et JP2013008748A. Toutefois, l'intégration d'un dissipateur de chaleur au-dessus de la puce électronique basse complexifie la fabrication du circuit intégré.

De l'état de la technique est également connu de : US2013043581A1, EP1271649A2, US2006039118A1, et US2008237840A1.

L'invention vise à remédier à cet inconvénient en proposant un circuit intégré qui comporte un dissipateur de chaleur qui permet de mieux refroidir la puce électronique basse sans pour autant trop complexifier la réalisation du circuit intégré.

Elle a donc pour objet un circuit intégré conforme à la revendication 1.

Grâce à la présence à l'intérieur du circuit intégré du dissipateur de chaleur, qui compense la différence de hauteur entre les faces arrières des puces haute et basse, un pont thermique est établi entre la face arrière de la puce électronique basse et la face extérieure supérieure. Cela améliore très sensiblement le refroidissement de la puce électronique basse à partir de la face extérieure supérieure. Dès lors, il n'est plus nécessaire de sur-dimensionner autant le système de refroidissement de la face extérieure supérieure pour obtenir le même refroidissement de la puce électronique basse que dans les circuits intégrés connus.

De plus, la présence de plots sur la face avant du dissipateur et sur la face arrière de la puce électronique basse simplifie l'intégration du dissipateur de chaleur dans le circuit intégré. En effet, il est alors possible d'utiliser les procédés classiques de fixation d'une puce électronique sur des plots en vis-à-vis pour fixer le dissipateur de chaleur sur la face arrière de la puce électronique basse. Cela simplifie donc grandement l'intégration de ce dissipateur dans le circuit intégré puisqu'il n'est pas nécessaire de mettre en oeuvre pour cela un procédé spécifique de fixation du dissipateur sur la puce électronique basse.

Les modes de réalisation de ce circuit intégré peuvent présenter une ou plusieurs des caractéristiques des revendications dépendantes.

Les modes de réalisation de ce circuit intégré présentent en outre les avantages suivants :
- la présence de plots sur le dissipateur, identiques aux plots déjà utilisés pour raccorder électriquement la puce électronique haute permet de simplifier la fixation du dissipateur sur la face arrière de la puce électronique basse, car le même procédé de fixation est utilisé à la fois pour la puce électronique haute et le dissipateur ;
- une face avant plane du dissipateur permet d'assurer une surface de contact plus importante avec la face arrière de la puce électronique basse et donc d'améliorer l'efficacité du refroidissement de cette puce électronique basse ;
- avoir une surface de contact mécanique entre la face avant du dissipateur et la face arrière de la puce électronique basse, supérieure à 10 % de la surface de la projection orthogonale de cette face arrière permet d'augmenter l'efficacité du refroidissement de la puce électronique basse ;
- avoir une surface de la projection orthogonale de la face avant du dissipateur strictement supérieure à la surface de la projection orthogonale de la face arrière de la puce électronique basse permet d'augmenter la diffusion latérale de la chaleur et donc d'augmenter l'efficacité du refroidissement de la puce électronique basse.

L'invention a également pour objet un ensemble comportant :
- le circuit intégré ci-dessus présentant une face extérieure supérieure, et
- un radiateur ou un système de refroidissement fluidique utilisant un liquide caloporteur pour refroidir la face extérieure supérieure du circuit intégré, le radiateur ou le système de refroidissement fluidique étant directement disposé sur la face extérieure supérieure de ce circuit intégré.

L'invention a également pour objet un procédé de fabrication du circuit intégré ci-dessus.

Les modes de réalisation de ce procédé de fabrication peuvent comporter une ou plusieurs des caractéristiques des revendications dépendantes.

L'invention sera mieux comprise à la lecture de la description qui va suivre, donnée uniquement à titre d'exemple non limitatif, et faite en se référant aux dessins sur lesquels :
- la figure 1 est une illustration schématique en coupe verticale d'un ensemble comportant un circuit intégré et un système de refroidissement de ce circuit intégré ;
- la figure 2 est un organigramme d'un procédé de fabrication de l'ensemble de la figure 1 ;
- les figures 3 à 13 sont des illustrations schématiques en coupe verticale, de différentes étapes du procédé de fabrication de la figure 2 ;
- la figure 14 est une illustration schématique en coupe verticale, d'un deuxième mode de réalisation non revendiqué d'un ensemble comportant un circuit intégré et un système de refroidissement de ce circuit intégré ;
- la figure 15 est un organigramme d'un procédé de fabrication de l'ensemble de la figure 14 ;
- les figures 16 à 27 sont des illustrations schématiques en coupe verticale de différentes étapes du procédé de la figure 15 ;
- la figure 28 est une illustration schématique d'un troisième mode de réalisation non revendiqué d'un ensemble comportant un circuit intégré et un système de refroidissement de ce circuit intégré.

Dans ces figures, les mêmes références sont utilisées pour désigner les mêmes éléments. Dans la suite de cette description, les caractéristiques et les fonctions bien connues de l'homme du métier ne sont pas décrites en détail.

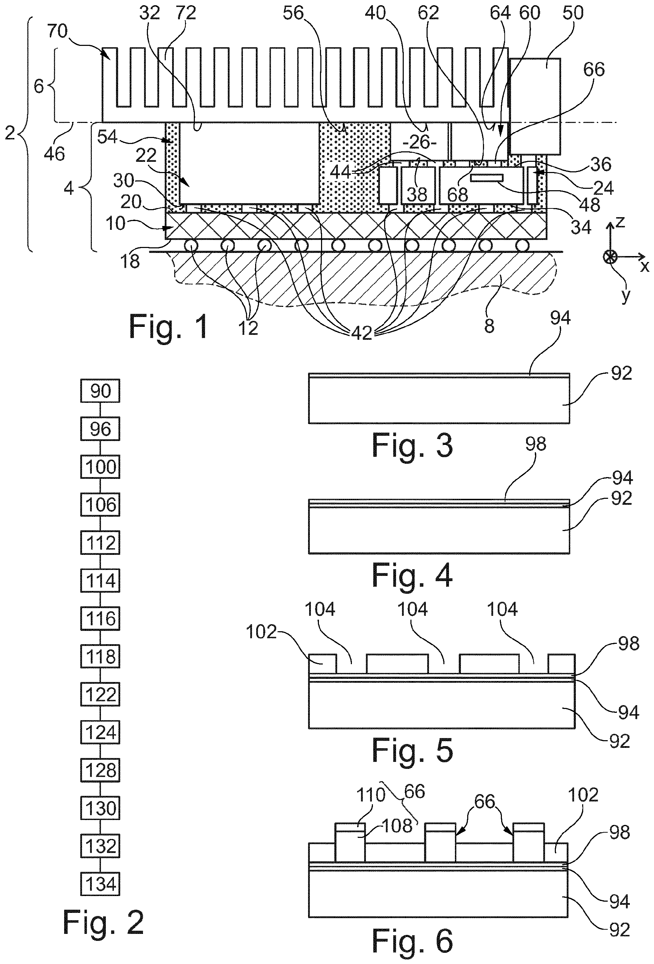

La figure 1 représente un ensemble 2 comportant un circuit intégré 4 et un système 6 de refroidissement de ce circuit intégré 4.

Le circuit intégré 4 est conçu pour traiter des signaux afin de remplir une ou plusieurs fonctions prédéterminées. Les signaux traités sont des signaux électriques ou optiques.

Ce circuit intégré 4 est électriquement raccordé à un circuit électronique extérieur. Typiquement, il est monté sur une carte ou circuit imprimé 8 du circuit électronique extérieur. Sur la figure 1, seule une portion du circuit imprimé 8 est représentée. À cet effet, le circuit intégré 4 comporte un substrat 10 équipé de connexions électriques 12. Les connexions 12 raccordent électriquement et mécaniquement le circuit intégré 4 à des pistes électriques du circuit imprimé 8. Sur la figure 1, les pistes du circuit imprimé 8 n'ont pas été représentées.

Le substrat 10 s'étend essentiellement horizontalement parallèlement à un plan appelé « plan du substrat ». Le plan du substrat est parallèle à des directions orthogonales X et Y. La direction verticale sur les figures est représentée par une direction Z perpendiculaire aux directions X et Y. Ici, les termes tels que « dessus », « dessous », « supérieur » et « inférieur » sont définis par rapport à la direction Z.

Les connexions 12 sont, par exemple, des billes fusibles situées sur une face extérieure 18 horizontale du substrat 10. La face extérieure 18 est située du côté opposé à une face intérieure 20 horizontale. Ces billes fusibles sont soudées sur des pistes correspondantes du circuit imprimé 8. De telles connexions électriques sont également connues sous le terme de « micro-piliers ». Cet assemblage de billes est connu sous l'acronyme BGA (« Bail Grid Array »). Les billes sont, par exemple, réalisées dans un métal conducteur tel que du cuivre, mélangé avec un matériau de fluage tel que de l'étain.

Le substrat 10 comporte également des pistes électriques raccordant électriquement des plots de connexion des puces électroniques à des connexions 12 respectives. Pour simplifier la figure 1, ces pistes électriques du substrat 10 n'ont pas été représentées.

Typiquement, le substrat 10 est réalisé dans un matériau dur dont la dureté est par exemple supérieure ou égale à celle du silicium. Ici, le substrat 10 est réalisé en silicium. L'épaisseur du substrat 10 est typiquement supérieure à 100 µm ou 300 µm.

Le circuit intégré 4 est un circuit intégré à trois dimensions, c'est-à-dire qu'à l'intérieur du boîtier de ce circuit intégré, on trouve au moins deux puces électroniques empilées l'une au-dessus de l'autre dans la direction verticale Z.

A titre d'illustration, le circuit intégré 4 comporte trois puces électroniques 22, 24 et 26.

De façon générale, une puce électronique comporte de nombreux composants électriques actifs ou passifs pour réaliser une fonction prédéterminée. Un composant électrique actif est défini comme étant un composant électronique qui permet d'augmenter la puissance d'un signal, par exemple la tension ou le courant ou les deux. La puissance supplémentaire est récupérée au travers d'une alimentation. Il s'agit typiquement de composants réalisés à partir de semi-conducteurs tels que des transistors ou des thyristors. Il peut aussi s'agir d'un composant optoélectronique. A l'inverse, un composant électronique passif est défini comme ne permettant pas d'accroître la puissance d'un signal. Il s'agit typiquement d'une résistance, d'un condensateur, d'une inductance ou d'une bobine ou encore d'une diode ou de tout assemblage de ces composants.

Une puce électronique est également connue sous le terme anglais de « die ». Elle inclut une face avant tournée vers le substrat 10 et, du côté opposé, une face arrière. Ces faces avant et arrière s'étendent essentiellement parallèlement au plan du substrat. Typiquement, les composants actifs ou passifs de la puce électronique sont réalisés dans l'une des faces avant ou arrière ou encore à l'intérieur de cette puce. Par exemple, dans ce mode de réalisation, les composants actifs ou passifs sont réalisés dans la face avant de chaque puce. Les faces avant et arrière sont chacune formée par une couche de passivation éventuellement traversée par des plots de connexions électriques. La couche de passivation isole électriquement la puce de l'environnement extérieur. Les plots de connexions raccordent électriquement et mécaniquement la puce à d'autres puces du circuit intégré 4 ou au substrat 10. Ces plots permettent à chaque puce d'échanger des signaux électriques avec ces autres puces ou avec le substrat 10.

Ici, les faces avant et arrière des puces 22, 24 et 26 portent, respectivement, les références numériques 30 et 32, 34 et 36, 38 et 40. Plus précisément, les faces avants 30 et 34 sont directement raccordées mécaniquement et électriquement sur la face intérieure 20 du substrat 10 par des plots 42 de connexions électriques. Par exemple, ces plots de connexions électriques sont également réalisées au moyen de microbilles fusibles ou micro-piliers formant un ensemble BGA. Par exemple, les faces 30 et 34 comportent chacune un fond plat à partir duquel les plots 42 font saillie verticalement.

La face avant 38 de la puce 26 est mécaniquement et électriquement directement raccordée à la face arrière 36 de la puce 24. A cet effet, dans ce mode de réalisation, la face avant 38 et la face arrière 36 comportent chacune des plots 44 en vis-à-vis les uns des autres. Sur la figure 1, on n'a pas distinguer les plots 44 appartenant à la face 38 des plots en vis-à-vis appartenant à la face 36. Ces plots 44 sont de taille micrométrique et également connu sous le terme de « micro-piliers ». Plus précisément, ces faces comportent chacune un fond plat à partir duquel les plots 44 font saillie verticalement. Typiquement, la section horizontale de chaque plot 44 est constante sur l'essentielle de sa hauteur. Le diamètre de cette section horizontale est généralement compris entre 0,1 µm et 100 µm et, le plus souvent, entre 5 µm et 30 µm ou entre 5 µm et 20 µm. Ici, le diamètre des plots 44 est de 20 µm et l'espacement entre les plots 44 est de 50 µm. Lorsque la section horizontale des plots 44 n'est pas circulaire, par « diamètre », on désigne le diamètre hydraulique en considérant que la totalité du périmètre de la section horizontale est mouillé. La hauteur de chaque plot 44, mesurée depuis le fond plat, est généralement comprise entre 1 µm et 200 µm et, le plus souvent, entre 10 µm et 100 µm. Ces plots 44 sont réalisés en matériau électriquement conducteur. Ici, on considère qu'un matériau est électriquement conducteur si sa conductivité électrique à 20 °C est supérieure à 1 S/m et, de préférence, supérieure à 10⁵ ou 10⁷ S/m. Par exemple, les plots 44 sont réalisés en métal tel que du cuivre. D'autres détails sur les plots 44 sont donnés en regard du procédé de fabrication de l'ensemble 2.

Les faces arrières 32 et 40 sont situées à la même hauteur, c'est-à-dire dans un même plan horizontal 46. La face arrière 36 est située à une hauteur bien plus faible que celle des faces arrières 32 et 40. Par exemple, la face arrière 36 est située à plus de 50 µm ou 100 µm en dessous du plan 46.

Ici, les puces 22 et 26 comprennent, par exemple, des transistors MOS (« Metal Oxide Semiconductor ») et sont aptes à traiter des signaux électriques pour réaliser des calculs arithmétiques et logiques. Les puces 22 et 26 constituent donc des sources de chaleur lorsqu'elles fonctionnent pour réaliser des calculs à partir des signaux électriques fournis. Dans la suite de cette description, on désigne par source de chaleur une zone du circuit intégré dissipant une puissance surfacique supérieure à 1 W/cm². Par exemple, ici, la puissance surfacique dissipée par une source de chaleur est égale à 5 W/cm² ou 10 W/cm² ou 50 W/cm².

La puce 24 comprend un composant optoélectronique 48 tel qu'un générateur d'un faisceau laser. Par exemple, le composant 48 est utilisé pour convertir des signaux électriques en des signaux optiques transmis à l'extérieur du circuit intégré 4. A cet effet, le circuit intégré 4 comprend aussi un connecteur 50 permettant de raccorder un câble optique à la puce 24. Le composant 48 forme aussi une source de chaleur quand il fonctionne. En effet, une partie substantielle de l'énergie électrique reçue par ce composant 48 pour générer le faisceau laser est dissipée sous forme de chaleur.

Le circuit intégré 4 comprend un boîtier formé par une couche épaisse 54 . La couche 54 protége les puces 22, 24 et 26 et la face 20 du substrat contre des agressions mécaniques et chimiques provenant de l'environnement extérieur du circuit intégré 4. A cet effet, elle recouvre et enrobe directement :
- la face 20 du substrat 10,
- les faces verticales des puces 22, 24 et 26, et
- dans ce mode de réalisation, une partie de la face arrière 36 de la puce 24.

La couche 54 présente également une face extérieure supérieure 56 horizontale tournée du côté opposé au substrat 10. Ici, la face extérieure 56 est la face du circuit intégré 4 sur laquelle est directement monté le système 6 de refroidissement. Pour améliorer les échanges de chaleur entre les puces 22, 26 et le système 6, le plan 46 contenant les faces 32 et 40 est situé à moins 50 µm et, typiquement, à moins de 10 µm sous la face extérieure 56. De préférence, comme dans ce mode de réalisation, les faces 32 et 40 affleurent la face extérieure 56. Ici, la face extérieure 56 est donc contenue dans le plan 46.

Plus précisément, la couche 54 protège les puces 22, 24 et 26 contre l'humidité et les chocs mécaniques. A cet effet, en ce qui concerne l'humidité, la couche 54 satisfait le test d'étanchéité appelé « chaleur humide ». Un tel test d'étanchéité est par exemple défini dans les normes GEDEC. Cette norme définit notamment le test suivant :
1) caractérisation du circuit intégré sous condition standard,
2) placer le circuit intégré des centaines d'heures, typiquement plus de 500 heures, à 85 °C avec une humidité de 85 %, ensuite
3) caractériser le fonctionnement du circuit intégré sous condition standard.

Si les valeurs relevées lors des points 1) et 3) ci-dessus sont égales à une marge d'erreur prédéfinie par la norme GEDEC, alors la couche 54 est dite étanche.

Pour protéger les puces électroniques contre les chocs, la couche épaisse est réalisée dans un matériau qui permet de répartir et d'abaisser les contraintes mécaniques entre les puces 22, 24 et le substrat 10. Par exemple, à cet effet, le module de Young à 25 °C de la couche 54 est choisi strictement inférieur à celui des puces 22 et 24. Typiquement, le module de Young des puces 22, 24 est sensiblement égal au module de Young du silicium. Le module de Young de la couche 54 est alors choisi généralement inférieur à 100 GPa ou à 20 GPa à 25 °C.

La couche 54 est aussi électriquement isolante pour isoler électriquement les puces 22, 24 et 26 de l'environnement extérieur. Ici, on considère qu'une couche est électriquement isolante si sa conductivité à 20 °C est inférieure à 10⁻⁴ S/m et, de préférence, inférieure à 10⁻⁷ ou 10⁻¹⁰ S/m.

Pour atteindre ces résultats, généralement, la couche 54 comporte un certain volume de polymère qui varie de 5% à 100% du volume total de la couche 54. Le volume de polymère est souvent supérieur à 50 % du volume total. Typiquement, le polymère est uniformément réparti dans la couche 54. Il peut s'agir par exemple d'une résine époxy.

De plus, généralement, la couche 54 présente une faible conductivité thermique, c'est-à-dire une conductivité thermique à 20 °C inférieure à 50 W.m⁻¹.K⁻¹ et, typiquement, inférieure à 15 W.m⁻¹.K⁻¹ ou 5 W.m⁻¹.K⁻¹ ou 2 W.m⁻¹.K-¹.

Étant donné la faible conductivité thermique de la couche épaisse 54 et le fait que la face arrière 36 est éloignée, typiquement de plus de 50 µm, de la face extérieure 56, il est difficile de refroidir efficacement la puce 24 à l'aide du système 6 de refroidissement. Pour éviter ce problème, le circuit intégré 4 comporte un dissipateur 60 de chaleur interposé entre la face arrière 36 et la face extérieure 56.

Le dissipateur 60 est un bloc de matériaux thermiquement bon conducteur ayant pour fonction d'établir un pont thermique entre la zone de la face arrière 36 qui s'échauffe le plus et la face extérieure 56. Ici, la zone de la face arrière 36 qui s'échauffe le plus est située à la verticale du composant opto-électronique 48. Par la suite, par bon conducteur thermique, on désigne un matériau ou un bloc de matériau dont la conductivité thermique à 25 °C, dans la direction verticale, est au moins deux fois supérieure à la conductivité thermique de la couche épaisse 54 mesurée dans les mêmes conditions et dans la même direction. De préférence, la conductivité thermique du dissipateur 60 dans la direction verticale est au moins quatre, dix ou cinquante fois supérieure à la conductivité thermique de la couche 54 dans la même direction. Ainsi, typiquement, la conductivité thermique à 25 °C du bloc 60 est supérieure à 10 W/m/K ou 100 W/m/K et, de préférence, supérieure à 200 W/m/K ou 300 W/m/K.

Le dissipateur 60 ne remplit aucune autre fonction que celle de dissipateur de chaleur. Par conséquent, il est dépourvu de composant électronique actif ou passif. De plus, il est de préférence électriquement isolé des puces électroniques et du substrat 10 ou alors uniquement raccordé électriquement à la masse du circuit intégré 4.

Le dissipateur 60 comporte une face avant 62 en vis-à-vis de la face arrière 36 et une face arrière 64 située du côté opposé à cette face avant 62. Ces faces 62 et 64 s'étendent principalement horizontalement. La surface de la projection orthogonale de la face avant 62 dans un plan horizontale est supérieure à 10 % et, de préférence, supérieure à 20 % ou 40 % de la surface de la projection orthogonale de la face arrière 36 dans ce même plan.

La face 62 est directement en contact avec la face arrière 36. Ici, la face 62 comporte un fond plat horizontal et des plots 66 faisant saillie verticalement vers le bas à partir de ce fond. Ces plots 66 sont conçus pour être mécaniquement et thermiquement raccordés à des plots 44 de la face arrière 36 en vis-à-vis. Ces plots 66 sont structurellement identiques aux plots 44, sauf en ce qui concerne leur hauteur qui peut être différente de celle des plots 44. Ici, les plots 66 sont réalisés dans le même matériau que les plots 44, car le cuivre est un matériau bon conducteur thermique. Toutefois, d'autres matériaux bons conducteurs thermiques sont possibles pour les plots 66.

Dans ce mode de réalisation, seule l'extrémité des plots 66 est en contact mécanique direct avec la face arrière 36. Le nombre et les dimensions des plots 66 sont déterminés pour que la surface de la face avant 62 en contact mécanique direct avec la face arrière 36 soit au moins supérieure à 10 ou 20 % et, de préférence supérieure à 35 % ou 45 %, de la surface de la projection orthogonale de cette face avant 62 dans un plan horizontal. Ici, la surface de la face avant 62 directement mécaniquement en contact avec la face arrière 36 est comprise entre 30 % et 50 % de la surface de la projection orthogonale de la face avant 62 sur un plan horizontal. Ici, les plots 66 font 20 µm de diamètre et sont espacés les uns des autres avec un pas de 50 µm.

La face arrière 64 est plane et horizontale. Cette face arrière est située au même niveau que les faces arrières 32 et 40 des puces 22 et 26 dites hautes. Ici, une puce est dite « haute » si elle possède la face arrière la plus éloignée de la face intérieure 10 du substrat. A l'exception de la ou des puces hautes, les autres puces du circuit intégré sont dites « basses ». Ainsi, ici, la puce 24 est une puce basse car elle présente une face arrière 68 plus proche de la face intérieure 10 que les faces 32 ou 40. Par « situé au même niveau », on désigne le fait que la face 64 se situe entre une premier et un second plans horizontaux situés, respectivement, en-dessous et au-dessus de la face arrière de la puce haute. La hauteur du premier plan est égale à la hauteur H de la face arrière de la puce haute moins 0,15*H ou moins 0,10*H ou moins 0,05*H (le symbole « » signifie « multiplié par »). La hauteur du second plan est égale à la hauteur H plus 0,15*H ou plus 0,10*H ou plus 0,05*H. La hauteur H est la hauteur de la face arrière de la puce haute par rapport à la face intérieure 20 du substrat 10. La hauteur H est mesurée verticalement. Par exemple, la hauteur de la face arrière 64 est égale à la hauteur de la face arrière 32 ou 40 à plus ou moins 10 µm près ou plus ou moins 5 µm près. A titre d'illustration, ici, la hauteur H est égale ou supérieure à 100 µm. De plus, avantageusement, la face arrière 64 est comprise entre le plan 46 et un autre plan horizontal situé à moins de 50 µm ou 10 µm sous le plan 46. De préférence, comme représentée ici, la face arrière 64 affleure la face extérieure 56. Ici, elle est donc située dans le plan 46.

Les faces avants 62 et arrière 64 sont mécaniquement reliées les unes aux autres par des faces verticales. La hauteur du dissipateur 60 mesurée entre le fond plat et la face arrière 64 est, typiquement, supérieure à 10 µm ou 100 µm, et généralement inférieure à 700 µm. Ici, cette hauteur est comprise entre 100 µm et 300 µm.

Pour assurer une dissipation rapide de la chaleur vers le système 6 de refroidissement, le dissipateur 60 doit conduire rapidement la chaleur et ne pas trop l'emmagasiner. Le dissipateur 60 ne comprend donc pas de matériau à changement de phase ou PCM (« Phase Change Material »). A cet effet, le matériau dans lequel est réalisé le corps du dissipateur représente une capacité thermique massique, mesurée dans les conditions normales de température et de pression inférieure à 1 250 J/Kg/K ou inférieure à 1 000 J/Kg/K ou encore inférieure à 750 J/Kg/K. Le corps du dissipateur 60 est la partie située entre le fond plat de la face avant 62 et la face arrière 64, c'est-à-dire le dissipateur sans les plots 66. Ici, ce corps est un bloc thermiquement homogène en un seul matériau. Le corps du dissipateur 60 n'est pas nécessairement réalisé dans le même matériau que les plots 66. Ici, il est réalisé en silicium ou en aluminium.

Pour améliorer la conduction thermique entre la face avant 62 et la face arrière 36, les interstices entre les plots 44 et 66 sont remplis d'une colle 68 réalisée dans un matériau de collage bon conducteur thermique. Par exemple, ce matériau de collage comprend un matériau polymère mélangé avec des particules en matériau thermiquement bon conducteur. Par exemple, les particules sont des particules de métal telles que des particules de cuivre ou d'argent. Les particules peuvent aussi être des particules de graphènes ou de graphites ou d'autres matériaux tels que de l'oxyde de silicium. Ces particules se présentent généralement sous la forme de nanoparticules, c'est-à-dire de particules dont la plus grande longeur est inférieure à 1 µm et, typiquement, inférieure à 100 nm ou 10 nm.

Le système 6 de refroidissement comporte un radiateur 70. Ce radiateur 70 possède une face plane directement en contact mécanique et thermique avec la face extérieure 56. Cette face plane recouvre la totalité des faces arrière 32, 40 et 62. Du côté opposé, le radiateur 70 présente un fond plat à partir duquel des ailettes 72 font saillis pour accroître la surface de contact entre ce radiateur 70 et le milieu extérieur, et ainsi favoriser les échanges de chaleur par conduction avec ce milieu extérieur.

Le fonctionnement du circuit intégré 4 est le suivant. Lorsque le composant 48 fonctionne, il génère de la chaleur. Cette chaleur se diffuse préférentiellement par conduction de la face arrière 36 vers la face avant 62 du dissipateur 60, puis de la face avant 62 jusqu'à la face arrière 64 et, enfin, de la face arrière 64 vers le radiateur 70. La présence du dissipateur 60 accélère l'échange de chaleur entre la face arrière 36 et le radiateur 70. Cela permet de maintenir la face arrière 36 à une température T1 très inférieure à celle qui serait observée en absence du dissipateur 60. Des simulations ont montré qu'en fonctionnement normal, la température T1 est d'au moins 10 °C ou 20 °C, voire même inférieure d'au moins 50 °C par rapport à la température qui serait observée dans les mêmes conditions et dans un circuit intégré identique mais dépourvu du dissipateur 60.

Un procédé de fabrication de l'ensemble 2 va maintenant être décrit en référence aux figures 2 à 13.

Le procédé débute par la fabrication collective du dissipateur 60. Plus précisément, lors d'une étape 90 (figure 3), une plaque de silicium 92 est fournie puis oxydée pour former au-dessus de cette plaque une couche d'oxyde de silicium 94.

Lors d'une étape 96 (figure 4), une couche d'accroche et une couche de nucléation sont déposées sur la couche 94. Sur la figure 4, ces couches sont représentées par une même couche 98. La couche d'accroche est par exemple en titane ou en nitrure de titane et la couche de nucléation est ici en cuivre.

Lors d'une étape 100 (figure 5), une couche 102 de résine est déposée sur la couche 98 puis structurée par photolithographie pour aménager des emplacements 104 où la couche 98 est directement exposée à l'extérieur.

Lors d'une étape 106 (figure 6), on procède à la croissance, par électrolyse, de plots en cuivre à partir du fond des emplacements 104. L'extrémité libre de chaque plot en cuivre est ensuite recouverte d'une couche 110 de finition dans un matériau de fluage. Ici, le matériau de fluage est un alliage SnAg. On obtient ainsi les plots 66. Sur les figures, le nombre de plots 66 représentés à été limité pour simplifier les illustrations graphiques.

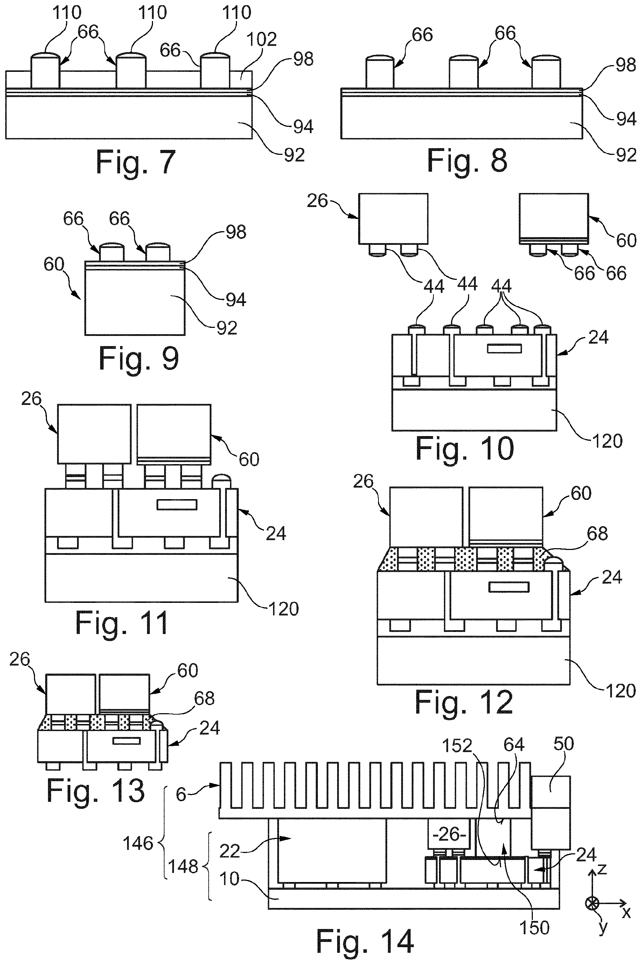

Lors d'une étape 112 (Figure 7), on procède à un traitement thermique de mise en forme de l'alliage SnAg. Cela permet d'éviter que cet alliage métallique ne coule sur les bords verticaux des plots 66 lors de l'étape de fluage ultérieur.

Lors d'une étape 114 (figure 8), la couche 102 de résine est retirée, par exemple, par dissolution.

Lors d'une étape 116 (figure 9), la plaque 92 de silicium est découpée pour séparer mécaniquement les uns des autres les différents dissipateurs 60 fabriqués collectivement jusqu'à présent.

Lors d'une étape 118 (figure 10), le dissipateur 60 et la puce 26 sont assemblés et reportés sur la face arrière 36 de la puce 24. À cet effet, la puce 26 et le dissipateur 60 sont amenés et positionnés sur la face arrière 36 à l'aide d'un même procédé connu sous le terme anglais de « pick and place ». Lors de l'étape 118, cette étape est réalisée sur une plaque contenant plusieurs puces 24 de manière à réaliser l'empilement de la puce 26 et du dissipateur 60 collectivement sur plusieurs puces 24. Pour rigidifier la plaque contenant les différentes puces 24, un substrat temporaire ou poignée temporaire 120 est collé sur cette plaque. Sur la figure 10, seule une puce 24 de cette plaque est représentée.

Lors d'une étape 122 (figure 11), un traitement thermique est appliqué pour faire fluer les alliages SnAg. Cela permet de souder mécaniquement les plots 44 et 66 entre eux. Ce raccordement mécanique permet aussi d'obtenir un raccordement électrique et thermique entre ces plots. Le traitement thermique est appliqué simultanément aux plots 44 des puces 24 et 26 et aux plots 66 du dissipateur 60. Ainsi, la fixation mécanique de la puce 26 et du dissipateur 60 sur la face arrière 36 de la puce 24 est réalisée en une seule opération.

Lors d'une étape 124 (figure 12), la colle 68 est dispersée entre les plots 44 et 66 pour remplir complètement les interstices situés entre ces plots. Cela améliore la tenue mécanique du dissipateur 60 sur la face arrière 36 de la puce 24. Cela améliore également le raccordement thermique du dissipateur 60 sur la face arrière 36. Éventuellement, comme illustré ici, la même colle 68 est également dispersée entre les puces 24 et 26.

Lors d'une étape 128 (figure 13), la poignée temporaire 120 est décollée, puis la plaque contenant les différentes puces 24 est découpée de façon à isoler mécaniquement les uns des autres des sous-ensembles comportant chacun une puce 24 sur laquelle sont fixés la puce 26 et le dissipateur 60.

Ensuite, lors d'une étape 130, un sous-ensemble obtenu à l'étape 128 est soudé sur le substrat 10. Lors de cette étape 130, la puce 22 est également soudée sur le substrat 10. Le positionnement du sous-ensemble ainsi que le positionnement de la puce 22 sur le substrat 10, lors de cette étape 130, sont, par exemple, réalisés à l'aide du même procédé « pick and place ».

Lors d'une étape 132, la couche épaisse 54 est moulée sur le substrat 10 et les puces 22, 24 et 26 et le dissipateur 60, de manière à former le boîtier du circuit intégré 4.

Enfin, lors d'une étape 134, le système 6 de refroidissement est directement fixé sur la face extérieure 56 du circuit intégré 4.

La figure 14 représente un ensemble 146 identique à l'ensemble 2, sauf que le circuit intégré 4 est remplacé par un circuit intégré 148. Le circuit intégré 148 est identique au circuit intégré 4, sauf que le dissipateur 60 est remplacé par un dissipateur 150. Le dissipateur 150 diffère du dissipateur 60 uniquement :
- par le fait que la face avant 62 est remplacée par une face avant 152 plane, et
- par le fait que le corps du dissipateur 150 est réalisé en cuivre et non pas en silicium.

Dans ce mode de réalisation, la face avant 152 est dépourvue de plot 66. Elle est directement en contact mécanique avec la face arrière 36 de la puce 24 sur toute sa surface. À cet effet, la face avant 152 est en appui sur une zone plane de la face arrière 36, c'est-à-dire une zone de la face arrière 36 dépourvue de plot 44.

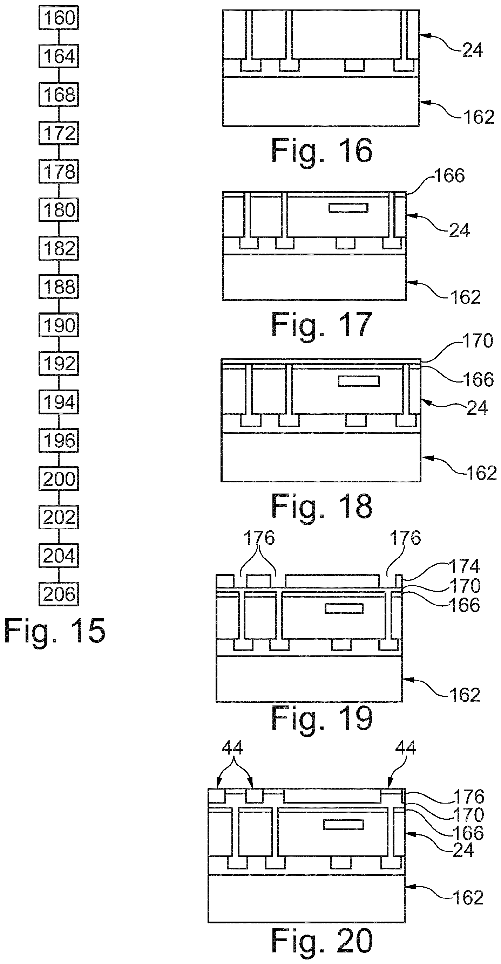

Un procédé de fabrication de l'ensemble 146 va maintenant être décrit en référence aux figures 15 à 27.

Lors d'une étape 160 (figure 16), une plaque sur laquelle ont été fabriquées collectivement plusieurs puces électroniques 24 est fournie. Cette plaque est collée sur une poignée temporaire 162. Pour simplifier les figures, seule une partie de cette plaque contenant uniquement une seule puce 24 est représentée.

Lors d'une étape 164 (figure 17), la fabrication de la puce 24 est achevée par le dépôt d'une couche de passivation 166 pour former la face arrière 36 de la puce 24. La couche 166 est réalisée dans un matériau électriquement isolant et recouvre tout l'arrière de la puce 24, sauf les emplacements où des plots 44 doivent être réalisés.

Lors d'une étape 168 (figure 18), une couche d'accroche et une couche de nucléation sont déposées. Cette étape est par exemple identique à l'étape 96 du procédé de la figure 2. Sur les figures, ces deux couches sont représentées par une seule couche 170.

Lors d'une étape 172 (figure 19), une couche de résine 174 est déposée, puis structurée par photolithographie pour former des emplacements 176. Au fond de chaque emplacement 176, une portion de la couche 170 est directement exposée à l'extérieur.

Lors d'une étape 178 (figure 20), les emplacements 176 sont remplis, par électrolyse, avec du cuivre, puis surmontés d'une couche de fluage en SnAg pour former les plots 44 de la face arrière 36 de la puce 24.

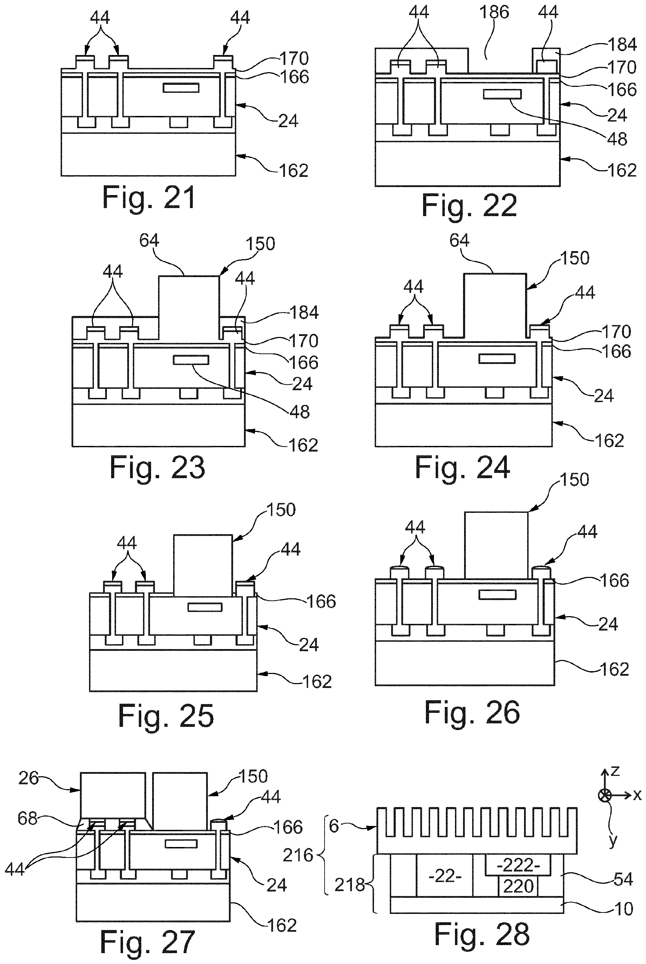

Lors d'une étape 180 (figure 21), la couche de résine 176 est retirée, par exemple, par dissolution.

Lors d'une étape 182 (figure 22), une nouvelle couche de résine 184 est déposée, puis structurée par photolithographie pour ménager un emplacement 186 au-dessus du composant 48. L'emplacement 186 permet d'exposer à l'extérieur seulement la partie de la couche 170 située directement au-dessus du composant 48.

Lors d'une étape 188 (figure 23), on procède au dépôt et à la croissance, par électrolyse, d'une couche de cuivre seulement à l'intérieur de l'emplacement 186. La croissance de cette couche de cuivre est arrêtée quand l'épaisseur de cette couche est telle que la face arrière 64 se situe à la même hauteur que les faces arrières 32 et 40 des puces électroniques 22 et 26 après l'assemblage des puces 22, 24, 26 et du dissipateur 150 sur le substrat 10. A l'issue de l'étape 188, la fabrication du dissipateur 150 et sa fixation sur la puce 24 sont terminées.

Lors d'une étape 190 (figure 24), la couche de résine 184 est retirée, par exemple, par dissolution.

Lors d'une étape 192 (figure 25), la couche 170 située entre les plots 44 est retirée par gravure.

Lors d'une étape 194 (figure 26), un traitement thermique, identique à celui de l'étape 112 est appliqué pour mettre en forme les plots 44.

Lors d'une étape 196 (figure 27), la puce électronique 26 est assemblée sur la face arrière 36. Cette étape 196 est réalisée de la même manière que ce qui a été décrit en référence aux étapes 118, 122 et 124 du procédé de la figure 2. Toutefois, on notera que dans ce mode de réalisation, la colle 68 est uniquement dispersée entre les plots 44 situés sous la puce 26.

Ensuite, on procède à des étapes 200, 202, 204 et 206 identiques, respectivement, aux étapes 128, 130, 132 et 134 du procédé de la figure 2.

La figure 28 représente un ensemble 216 identique à l'ensemble 2, sauf que le circuit intégré 4 est remplacé par un circuit intégré 218. Ce circuit intégré 218 se distingue du circuit intégré 4 par le fait que la puce 24 et le dissipateur 60 sont remplacés, respectivement, par une puce électronique 220 et un dissipateur 222. Le dissipateur 222 est identique au dissipateur 150 sauf qu'il est plus large que la puce électronique 220. Par conséquent, sa face avant s'étend, dans une direction horizontale, et de chaque côté, au-delà de la face arrière de la puce 220. Une telle disposition du dissipateur 222 favorise en plus la dissipation de la chaleur générée par la puce 220 sur les côtés verticaux du circuit intégré 218. Dans ce mode de réalisation, par exemple, le dissipateur 222 possède une face avant plane et dépourvue de plot qui est directement collée sur la face arrière de la puce électronique 220. Dans ce cas, la face arrière de la puce électronique 220 est également plane et horizontale. La colle utilisée pour réaliser ce collage est par exemple la colle 68. Typiquement, la surface de la face avant du dissipateur 222 est au moins 1,1 fois et, de préférence 1,5 fois ou 2 fois, supérieure à la surface de la face arrière de la puce 220.

De nombreux autres modes de réalisation sont possibles. Par exemple, en variante, la puce 26 est omise. Dans ce cas, la hauteur du dissipateur 60 est ajustée pour que sa face arrière soit à la hauteur de la face arrière 32 de la puce 22. Dans un autre mode de réalisation, c'est la puce 22 qui est omise.

Ce qui a été décrit précédemment s'applique à tous circuits intégrés comportant plusieurs puces électroniques dont les faces arrière sont situées à des hauteurs différentes. Dans le cas où le circuit intégré comporte plusieurs puces présentant chacune une face arrière à une hauteur supérieure à celle de la face arrière 36, de préférence, la face arrière 64 du dissipateur est située au niveau de la face arrière de la puce électronique haute. On notera aussi que la puce 24 peut être remplacée par une autre puce dépourvue de composants opto-électroniques.

La face arrière d'une puce électronique ou du dissipateur n'est pas nécessairement plane et horizontale. Par exemple, elle peut présenter des aspérités. Dans ce cas, le plan de la face arrière utilisé pour mesurer la hauteur H est le plan horizontal qui minimise la moyenne quadratique (« root mean square » en anglais) des écarts verticaux entre ce plan et chaque point de cette face arrière.

Le circuit intégré peut aussi contenir plusieurs dissipateurs tels que les dissipateurs 60, 150 ou 222. Par exemple, plusieurs dissipateurs sont disposés sur différentes zones respectives de la même face arrière d'une puce électronique. Il est aussi possible de disposer plusieurs dissipateurs sur des faces arrières respectives de plusieurs puces électroniques différentes.

Les connexions électriques 12 peuvent prendre d'autres formes. Par exemple, en variante, les connexions électriques 12 sont des broches qui font saillie au-delà du boîtier du circuit intégré 4.

Les composants électroniques d'une puce ne sont pas uniquement réalisés sur la face avant de cette puce. Par exemple, en variante, les composants électroniques sont également réalisés sur la face arrière ou enclavés à l'intérieur de la puce électronique.

Le corps du dissipateur peut être réalisé dans d'autres matériaux thermiquement bons conducteurs, y compris dans le cas du dissipateur 60. Par exemple, ce corps est réalisé en cuivre ou en aluminium.

Le corps du dissipateur n'est pas forcément constitué d'une seule couche entre ses faces avant et arrière. Ainsi, en variante, le corps est constitué d'un empilement de plusieurs couches en matériaux thermiquement bons conducteurs, directement déposées les unes sur les autres dans la direction verticale. Par exemple, cet empilement comporte au moins une couche en silicium et au moins une couche en carbure de silicium. Dans un autre mode de réalisation, cet empilement comporte au moins une couche de graphite. En variante, l'une des couches peut aussi être une couche de graphène pour accroître la conductivité latérale du dissipateur.

Dans un autre mode de réalisation, la face arrière du dissipateur n'est pas affleurante sur la face supérieure extérieure 56, mais enfoui sous une fine lame de la couche épaisse 54. Typiquement, l'épaisseur de cette lame de couche épaisse est inférieure à 50 µm et, de préférence, inférieure à 10 µm ou 5 µm.

La face avant du dissipateur peut être fixée sur la face arrière de la puce électronique par d'autres moyens. Par exemple, en variante, les plots 44 et 66 sont omis et la face avant est fixée sur la face arrière uniquement au moyen d'une colle, telle que la colle 68. Dans ce cas, la face avant n'est pas directement en contact mécanique avec la face arrière de la puce électronique.

Les particules thermiquement conductrices mélangées aux matériaux de collage dans la colle 68 peuvent être omises.

De même, les colles dispensées sous la puce 26 et sous le dissipateur peuvent être différentes. Par exemple, la colle dispensée uniquement sous la puce 26 présente une conductivité thermique moindre que celle dispensée sous le dissipateur.

Dans le cas où le dissipateur est mécaniquement et thermiquement fixé sur la puce 24 par des plots, la colle dispensée entre ces pots peut être omise.

D'autres systèmes de refroidissement de la face extérieure supérieure du circuit intégré sont possibles. Par exemple, on peut utiliser un système de refroidissement fluidique comportant des canaux qui amènent un liquide caloporteur en contact direct avec la face 56 et des canaux qui évacuent ce liquide caloporteur après qu'il ait été réchauffé par conduction thermique avec cette face 56.

En variante, l'étape de suppression de la couche 170 résiduelle entre les plots 44 est omise.

## Revendications

1. Circuit intégré comportant :
- un substrat (10) qui s'étend principalement dans un plan appelé « plan du substrat », ce substrat étant équipé de connexions électriques pour raccorder électriquement le circuit intégré à un circuit électronique extérieur, ce substrat présentant une face intérieure (20),
- une puce électronique haute (22, 26) et une puce électronique basse (24; 220), chacune de ces puces électroniques étant électriquement raccordée aux connexions électriques par l'intermédiaire de ce substrat et chaque puce électronique comportant une face avant tournée vers la face intérieure du substrat et une face arrière du côté opposé à cette face avant, la face arrière (32) de la puce électronique haute étant située à une hauteur H au-dessus de la face intérieure (20) du substrat et étant plus éloignée de la face intérieure (20) du substrat que la face arrière (36) de la puce électronique basse,
- un boîtier formé par une couche épaisse (54) en matériau électriquement isolant qui enrobe les puces électroniques, cette couche épaisse formant une face extérieure supérieure (56) du boîtier parallèle au plan du substrat,
- un dissipateur (60 ; 150 ; 222) de chaleur dépourvu de composants électroniques et interposé entre la face arrière (36) de la puce électronique basse et la face extérieure supérieure (56) du boîtier, ce dissipateur comportant une face avant (62 ; 152) disposée sur la face arrière de la puce électronique basse et une face arrière (64) du côté opposé à la face avant, cette face arrière étant comprise entre un premier et un second plans parallèles au plan du substrat, le premier et le second plans étant situés, respectivement, à 0,15*H en-dessous et à 0,15*H au-dessus de la face arrière de la puce électronique haute,
la conductivité thermique à 25 °C du dissipateur dans une direction perpendiculaire au plan du substrat étant au moins deux fois supérieure à la conductivité thermique de la couche épaisse mesurée dans les mêmes conditions et dans la même direction, dans lequel :
- la face arrière (36) de la puce électronique basse comporte des plots (44), et
- la face avant (62) du dissipateur comporte des plots (66) mécaniquement fixés sur les plots (44) en vis-à-vis de la face arrière de la puce électronique basse,
**caractérisé en ce que** :
- le dissipateur est électriquement isolé des puces électroniques et du substrat ou alors uniquement raccordé électriquement à la masse du circuit intégré, et
- la face arrière (64) du dissipateur est comprise entre un troisième plan (46) qui contient la face supérieure (56) du boîtier et un quatrième plan parallèle situé à moins de 50 µm sous le troisième plan (46).

2. Circuit intégré selon la revendication 1, dans lequel :
- la face avant (30, 38) de la puce électronique haute comporte des plots (42, 44), ces plots étant directement mécaniquement et électriquement raccordés sur des plots (44) en vis-à-vis de manière à transmettre des signaux électriques entre la puce électronique haute et un circuit électronique (8) extérieur à cette puce électronique haute par l'intermédiaire de ces plots,
- les plots (66) de la face avant du dissipateur sont mécaniquement fixés sur les plots (44) en vis-à-vis de la face arrière de la puce électronique basse de la même manière que les plots (42, 44) de la face avant de la puce électronique haute sont fixés sur les plots en vis-à-vis.

3. Circuit selon la revendication 2, dans lequel les faces avant du dissipateur et de la puce électronique haute comportent chacune un fond plat à partir duquel les plots (42, 44, 66) font saillie.

4. Circuit selon l'une quelconque des revendications précédentes, dans lequel les plots sont réalisés en métal.

5. Circuit selon l'une quelconque des revendications précédentes, dans lequel la partie de la face avant (62 ; 152) du dissipateur directement en contact mécanique avec la face arrière (36) de la puce électronique basse occupe au moins 10 % ou 30 % de la surface de la projection orthogonale de la face arrière de la puce électronique basse sur le plan du substrat.

6. Circuit selon la revendication 5, dans lequel la surface de la projection orthogonale de la face avant du dissipateur (222) sur le plan du substrat est au moins 1,1 fois supérieure à la surface de la projection orthogonale de la face arrière de la puce électronique basse (220) sur ce même plan.

7. Circuit selon l'une quelconque des revendications précédentes, dans lequel la capacité thermique massique du dissipateur est inférieure à 1200 J/Kg/K ou à 1000 J/Kg/K dans les conditions normales de température et de pression.

8. Circuit selon l'une quelconque des revendications précédentes, dans lequel l'épaisseur du dissipateur dans une direction perpendiculaire au plan du substrat est supérieure à 70 µm.

9. Circuit selon l'une quelconque des revendications précédentes, dans lequel la face arrière (32, 40) de la puce électronique haute et la face arrière (64) du dissipateur affleurent la face extérieure supérieure du boîtier.

10. Ensemble comportant :
- un circuit intégré (4 ; 148 ; 218) présentant une face extérieure supérieure, et
- un radiateur (70) ou un système de refroidissement fluidique utilisant un liquide caloporteur pour refroidir la face extérieure supérieure du circuit intégré, le radiateur ou le système de refroidissement fluidique étant directement disposé sur la face extérieure supérieure de ce circuit intégré,
dans lequel le circuit intégré est conforme à l'une quelconque des revendications précédentes.

11. Procédé de fabrication d'un circuit intégré conforme à l'une quelconque des revendications 1 à 9, **caractérisé en ce que** le procédé comporte la réalisation (182, 188, 190,192, 194, 200, 202, 204) du dissipateur de chaleur interposée entre la face arrière de la puce électronique basse et la face extérieure supérieure du boîtier.

12. Procédé selon la revendication 11, dans lequel le dissipateur est reporté (118) sur la face arrière de de la puce électronique basse par l'intermédiaire de plots.

13. Procédé selon la revendication 12, **caractérisé en ce que** lorsque le dissipateur est reporté sur la face arrière de la puce électronique basse et fixé à cette puce électronique basse par des plots, le procédé comporte une étape (124) de remplissage de l'espace créé par les plots par une colle contenant des particules thermiquement conductrices.

## Patentansprüche

1. Integrierter Schaltkreis, umfassend:
- ein Substrat (10), das sich hauptsächlich in einer Ebene, "Substratebene" genannt, erstreckt, wobei dieses Substrat mit elektrischen Verbindungen ausgestattet ist, um den integrierten Schaltkreis mit einem externen elektronischen Schaltkreis elektrisch zu verbinden, wobei dieses Substrat eine Innenfläche (20) aufweist,
- einen hohen elektronischen Chip (22, 26) und einen niedrigen elektronischen Chip (24; 220), wobei jeder dieser elektronischen Chips mittels dieses Substrats mit elektrischen Verbindungen elektrisch verbunden ist und jeder elektronische Chip eine Vorderseite, die gegen die Innenseite des Substrats gedreht ist, und eine Rückseite auf der dieser Vorderseite entgegengesetzten Seite umfasst, wobei die Rückseite (32) des hohen elektronischen Chips sich auf einer Höhe H über der Innenfläche (20) des Substrats und weiter von der Innenfläche (20) des Substrats befindet als die Rückseite (36) des niedrigen elektronischen Chips,
ein Gehäuse, das durch eine dicke Schicht (54) aus einem elektrisch isolierenden Material gebildet ist, das die elektronischen Chips umhüllt, wobei diese dicke Schicht eine obere Außenseite (56) des Gehäuses parallel zur Substratebene bildet,
- einen Ableiter (60; 150; 222) für Wärme ohne elektronische Komponenten und zwischen die Rückseite (36) des niedrigen elektronischen Chips und die obere Außenseite (56) des Gehäuses gesetzt, wobei dieser Ableiter eine Vorderseite (62; 152), die auf der Rückseite des niedrigen elektronischen Chips angeordnet ist, und eine Rückseite (64) auf der der Vorderseite entgegengesetzten Seite umfasst, wobei diese Rückseite zwischen einer ersten und einer zweiten Ebene, die zur Substratebene parallel sind, liegt und die erste und die zweite Ebene sich auf 0,15*H unter bzw. auf 0,15*H über der Rückseite des hohen elektronischen Chips befinden,
wobei die Wärmeleitfähigkeit des Ableiters bei 25 °C in einer Richtung senkrecht zur Substratebene mindestens zweimal höher ist als die Wärmeleitfähigkeit der dicken Schicht, gemessen unter denselben Bedingungen und in derselben Richtung, wobei:
- die Rückseite (36) des niedrigen elektronischen Chips Kontaktinseln (44) umfasst, und
- die Vorderseite (62) des Ableiters Kontaktinseln (66) umfasst, die mechanisch an den gegenüberliegenden Kontaktinseln (44) der Rückseite des niedrigen elektronischen Chips befestigt sind,
**dadurch gekennzeichnet, dass**:
- der Ableiter gegen die elektronischen Chips und das Substrat elektrisch isoliert ist oder allein mit der Masse des integrierten Schaltkreises elektrisch verbunden ist, und
- die Rückseite (64) des Ableiters zwischen einer dritten Ebene (46), die die Oberseite (56) des Gehäuses enthält, und einer vierten Ebene, die sich mindestens 50 µm unter der dritten Ebene (46) befindet, liegt.

2. Integrierter Schaltkreis nach Anspruch 1, wobei:
- die Vorderseite (30, 38) des hohen elektronischen Chips Kontaktinseln (42, 44) umfasst, wobei diese Kontaktinseln elektrisch und mechanisch direkt mit gegenüberliegenden Kontaktinseln (44) derart verbunden sind, dass sie elektrische Signale zwischen dem hohen elektronischen Chip und einem zu diesem hohen elektronischen Chip externen elektronischen Schaltkreis (8) mittels dieser Kontaktinseln übertragen,
- die Kontaktinseln (66) der Vorderseite des Ableiters mechanisch an den Kontaktinseln (44) gegenüber der Rückseite des niedrigen elektronischen Chips auf dieselbe Weise befestigt sind, wie die Kontaktinseln (42, 44) der Vorderseite des hohen elektronischen Chips an den gegenüberliegenden Kontaktinseln befestigt sind.

3. Schaltkreis nach Anspruch 2, wobei die Vorderseiten des Ableiters und des hohen elektronischen Chips jeweils einen ebenen Untergrund bilden, von dem die Kontaktinseln (42, 44, 66) hervorstehen.

4. Schaltkreis nach einem der vorhergehenden Ansprüche, wobei die Kontaktinseln aus Metall ausgeführt sind.

5. Schaltkreis nach einem der vorhergehenden Ansprüche, wobei der Teil der Vorderseite (62; 152) des Ableiters, der direkt in mechanischem Kontakt mit der Rückseite (36) des niedrigen elektronischen Chips steht, mindestens 10 % oder 30 % der Oberfläche der orthogonal verlaufenden Rückseite des niedrigen elektronischen Chips auf der Substratebene einnimmt.

6. Schaltkreis nach Anspruch 5, wobei die Oberfläche des orthogonalen Verlaufs der Vorderseite des Ableiters (222) auf der Substratebene mindestens 1,1-mal größer ist als die Oberfläche der orthogonal verlaufenden Rückseite des niedrigen elektronischen Chips (220) auf dieser selben Ebene.

7. Schaltkreis nach einem der vorhergehenden Ansprüche, wobei die spezifische Wärmekapazität des Ableiters unter normalen Temperatur- und Druckbedingungen geringer als 1200 J/kg/K oder als 1000 J/kg/K ist.

8. Schaltkreis nach einem der vorhergehenden Ansprüche, wobei die Dicke des Ableiters in einer Richtung senkrecht zur Substratebene größer als 70 µm ist.

9. Schaltkreis nach einem der vorhergehenden Ansprüche, wobei die Rückseite (32, 40) des hohen elektronischen Chips und die Rückseite (64) des Ableiters an der äußeren Oberfläche des Gehäuses zum Vorschein kommen.

10. Anordnung, umfassend:
- einen integrierten Schaltkreis (4; 148; 218), der eine obere Außenseite aufweist, und
- einen Strahler (70) oder ein Fluid-Kühlsystem, das eine Wärmeträgerflüssigkeit verwendet, um die obere Außenfläche des integrierten Schaltkreises zu kühlen, wobei der Strahler oder das Fluid-Kühlsystem direkt auf der oberen Außenseite dieses integrierten Schaltkreises angeordnet ist,
wobei der integrierte Schaltkreis einem der vorhergehenden Ansprüche entspricht.

11. Verfahren zur Herstellung eines integrierten Schaltkreises, der einem der Ansprüche 1 bis 9 entspricht, **dadurch gekennzeichnet, dass** das Verfahren die Realisierung (182, 188, 190, 192, 194, 200, 202, 204) des Wärmeableiters umfasst, der zwischen die Rückseite des niedrigen elektronischen Chips und die obere Außenseite des Gehäuses gesetzt wird.

12. Verfahren nach Anspruch 11, wobei der Ableiter (118) mittels Kontaktinseln auf die Rückseite des niedrigen elektronischen Chips gesetzt wird.

13. Verfahren nach Anspruch 12, **dadurch gekennzeichnet, dass** das Verfahren beim Aufsetzen des Ableiters auf die Rückseite des niedrigen elektronischen Chips und Befestigen auf diesem niedrigen elektronischen Chip durch Kontaktinseln einen Schritt (124) der Füllung des durch die Kontaktinseln geschaffenen Raums durch einen Kleber, der wärmeleitende Teilchen enthält, umfasst.

## Claims

1. Integrated circuit comprising:
- a substrate (10) that extends mainly in a plane referred to as the "plane of the substrate", this substrate being equipped with electrical connections for electrically connecting the integrated circuit to an exterior electronic circuit and having an interior side (20);
- a top electronic chip (22, 26) and a bottom electronic chip (24; 220), each of these electronic chips being electrically connected to the electrical connections by way of the substrate and each electronic chip comprising a front side turned toward the interior side of the substrate and a back side opposite the front side, the back side (32) of the top electronic chip being located at a height H above the interior side (20) of the substrate and being further from the interior side (20) of the substrate than the back side (36) of the bottom electronic chip;
- an encapsulation formed by a thick layer (54) made of an electrically insulating material that coats the electronic chips, this thick layer forming an upper exterior side (56) of the encapsulation parallel to the plane of the substrate; and
- a heat sink (60; 150; 222) devoid of electronic components and interposed between the back side (36) of the bottom electronic chip and the upper exterior side (56) of the encapsulation, this sink comprising a front side (62; 152) placed on the back side of the bottom electronic chip and a back side (64) opposite the front side, this back side being comprised between a first and a second plane, which planes are parallel to the plane of the substrate, these first and second planes being located 0.15xH below and 0.15xH above the back side of the top electronic chip, respectively,
the thermal conductivity at 25°C of the sink in a direction perpendicular to the plane of the substrate being at least two times higher than the thermal conductivity of the thick layer measured under the same conditions and in the same direction;
in which:
- the back side (36) of the bottom electronic chip comprises pads (44); and
- the front side (62) of the sink comprises pads (66) that are mechanically fastened to facing pads (44) of the back side of the bottom electronic chip,
**characterized in that**:
- the heat sink is electrically insulated from the electronic chips and from the substrate or then electrically connected solely to the ground of the integrated circuit; and
- the back side (64) of the heat sink is comprised between a third plane (46) that contains the upper side (56) of the encapsulation and a parallel fourth plane located at least 50 µm under the third plane (46).

2. Integrated circuit according to Claim 1, in which:
- the front side (30, 38) of the top electronic chip comprises pads (42, 44), these pads being directly mechanically and electrically connected to facing pads (44) so as to transmit electrical signals between the top electronic chip and an electronic circuit (8) exterior to this top electronic chip by way of these pads; and
- the pads (66) of the front side of the sink are mechanically fastened to facing pads (44) of the back side of the bottom electronic chip in the same way as the pads (42, 44) of the front side of the top electronic chip are fastened to the facing pads.

3. Circuit according to Claim 2, in which the front sides of the sink and top electronic chip each comprise a flat base from which the pads (42, 44, 66) protrude.

4. Circuit according to any one of the preceding claims, in which the pads are made of metal.

5. Circuit according to any one of the preceding claims, in which the portion of the front side (62; 152) of the sink making direct mechanical contact with the back side (36) of the bottom electronic chip occupies at least 10% or 30% of the area of the orthogonal projection of the back side of the bottom electronic chip onto the plane of the substrate.

6. Circuit according to Claim 5, in which the area of the orthogonal projection of the front side of the sink (222) onto the plane of the substrate is at least 1.1 times larger than the area of the orthogonal projection of the back side of the bottom electronic chip (220) onto the same plane.

7. Circuit according to any one of the preceding claims, in which the specific heat capacity of the sink is lower than 1200 J/Kg/K or 1000 J/Kg/K under standard conditions for temperature and pressure.

8. Circuit according to any one of the preceding claims, in which the thickness of the sink in a direction perpendicular to the plane of the substrate is larger than 70 µm.

9. Circuit according to any one of the preceding claims, in which the back side (32, 40) of the top electronic chip and the back side (64) of the sink are flush with the upper exterior side of the encapsulation.

10. Assembly comprising:
- an integrated circuit (4; 148; 218) having an upper exterior side; and
- a radiator (70) or a fluidic cooling system using a heat-transfer fluid to cool the upper exterior side of the integrated circuit, the radiator or the fluidic cooling system being placed directly on the upper exterior side of the integrated circuit;
in which the integrated circuit is according to any one of the preceding claims.

11. Process for fabricating an integrated circuit according to any one of Claims 1 to 9, **characterized in that** the process comprises producing (182, 188, 190, 192, 194, 200, 202, 204) the heat sink interposed between the back side of the bottom electronic chip and the upper exterior side of the encapsulation.

12. Process according to Claim 11, in which the sink is added (118) to the back side of the bottom electronic chip by way of pads.

13. Process according to Claim 12, **characterized in that** once the sink has been added to the back side of the bottom electronic chip and fastened to this bottom electronic chip by pads, the process comprises a step (124) of filling the space created by the pads with an adhesive containing thermally conductive particles.
